(19) Europäisches Patentamt
European Patent Office
Office européen des brevets

(11) Veröffentlichungsnummer: **0 377 191 B1**

# (12) EUROPÄISCHE PATENTSCHRIFT

(45) Veröffentlichungstag der Patentschrift: **23.03.94**

(51) Int. Cl.5: **C07C 69/96**, G03F 7/027, C07C 68/02, C07D 335/16, C07D 295/104

(21) Anmeldenummer: **89123879.2**

(22) Anmeldetag: **23.12.89**

## (54) Strahlungsempfindliches, ethylenisch ungesättigte, copolymerisierbare Verbindungen und Verfahren zu deren Herstellung.

(30) Priorität: **31.12.88 DE 3844444**

(43) Veröffentlichungstag der Anmeldung: **11.07.90 Patentblatt 90/28**

(45) Bekanntmachung des Hinweises auf die Patenterteilung: **23.03.94 Patentblatt 94/12**

(84) Benannte Vertragsstaaten: **AT BE CH DE ES FR GB IT LI NL SE**

(56) Entgegenhaltungen: **EP-A- 0 083 185**

(73) Patentinhaber: **BASF Aktiengesellschaft**
**Carl-Bosch-Strasse 38**
**D-67063 Ludwigshafen(DE)**

(72) Erfinder: **Boettcher, Andreas, Dr.**
**Konrad-Adenauer-Ring 38**
**D-6907 Nussloch(DE)**
Erfinder: **Rehmer, Gerd, Dr.**
**Koenigsberger Strasse 1**
**D-6711 Beindersheim(DE)**

**EP 0 377 191 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft neuartige strahlungsempfindliche, ethylenisch ungesättigte Phenonderivate und ein verfahren zu ihrer Herstellung.

UV-lichtempfindliche Aceto- und Benzophenone werden häufig als sog. äußere Initiatoren strahlungsempfindlichen Polymeren zugesetzt (z.B. G. Li Bassi, J. Rad. Cur. 14, 18 (1987)). Im allgemeinen sind solche Arbeitsweisen aber nicht vollständig befriedigend, denn es treten nach Mischung mit dem Polymeren Probleme mit der Verträglichkeit, der Gleichförmigkeit der Verteilung, der Flüchtigkeit, des Geruches, der Toxizität, des Ausschwitzens und der Wanderung des Zusatzstoffes auf, die häufig zu einer unerwünschten, vorzeitigen und ungleichmäßigen Reaktion führen. Beim eigentlichen Belichtungsvorgang wird dann eine geringere Reaktivität aufgrund erniedrigter effektiver Initiatorkonzentrationen sowie nach dem Belichten eine Reihe störender Nebenreaktionen beobachtet.

Es ist bekannt, daß die genannten Probleme z.T. gelöst werden können, wenn der strahlungsempfindliche Initiator mit Monomeren nach einem üblichen Verfahren mischpolymerisiert, d.h. in eine Polymerkette eingebaut wird. Der lichtempfindliche Photoinitiator hängt mit einer Ankergruppe, dem sog. Spacer, am Basispolymeren. Der Spacer dient weiterhin dazu, den Einfluß der Basispolymerkette auf das photochemische Verhalten des Initiators zu reduzieren.

Copolymerisierbare Initiatoren haben daher prinzipiell folgenden Aufbau:

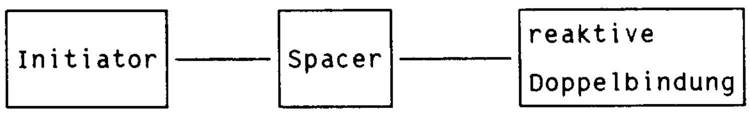


Schema I

In den US-Patentschriften 32 14 492, 34 29 852, 36 22 848 und 43 04 895 sind mit Acryloxy- oder Methacryloxygruppen substituierte Aceto- und Benzophenonderivate, wie z.B.

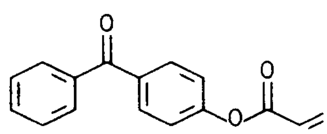

beschrieben. Diese können mit Ethylen oder anderen Vinylmonomeren mischpolymerisiert werden. Dabei entstehen Polymere, die beispielsweise nach der thermischen Verformung durch Bestrahlung gehärtet werden. Im Rahmen des Modells nach Schema I werden bei diesen strahlungsempfindlichen Monomeren die reaktive Doppelbindung und der Initiator durch die Carbonyloxygruppe als Spacer getrennt. Aus photochemischer Sicht sind diese Verbindungen weniger interessant, da der Acryloylsubstituent noch sehr stark die langwellige Absorption des Initiatorfragmentes beeinflußt.

In ähnlicher Weise ist dies auch bei den copolymerisierbaren Acetophenonacrylaten aus der DE-A-35 34 645 zu beobachten, bei denen die

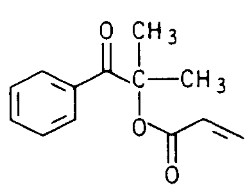

Photoreaktivität durch eine zu enge Kopplung der reaktiven Acrylatgruppe an das zur Carbonylgruppe α-ständige Kohlenstoffatom gesenkt wird. Die Ursache für dieses Verhalten ist darin zu sehen, daß bei der photochemisch initiierten α-Spaltung neben dem Benzoylradikal ein weiteres nur wenig reaktives Radikal gebildet wird.

Um die photochemische Aktivität des copolymerisierbaren Initiators im Vergleich zum Grundkörper nicht wesentlich zu verringern, muß die reaktive Doppelbindung vom Photoinitiatorteil mesomer und induktiv

abgekoppelt werden.

Beim 2-Acryloyl-thioxanthon (Eur. Polym. J. 23, 985 (1987))

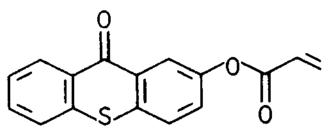

ist diese Trennung noch nicht vollständig gelungen. Das Copolymerisat mit Methylmethacrylat ist weniger reaktiv als 2-Hydroxythioxanthon.

Beim 4-(4'-Vinylbenzyloxy)benzophenon,

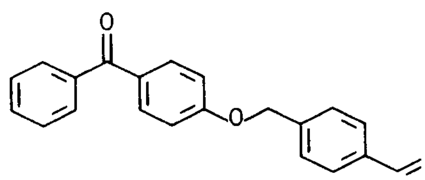

beschrieben in der DE-A-28 18 763, erweist sich der Styrylbenzyloxyrest als guter Spacer.

Beim "Uvecryl® P36", einem Handelsprodukt der Fa. UCB, trennt ein besonders langer Spacer aus vier Ethylenoxyeinheiten das Benzophenon vom Acryloxy-Rest.

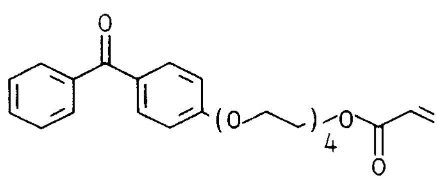

Diese z.B. im Technical Bulletin 2480/885 (1985) der Fa. UCB oder in New Polym. Mat. 1, 63 (1987) beschriebene Verbindung kann in Photopolymeren für Überzugsmassen eingesetzt werden. Die Synthese ist aufwendig und dieses Produkt ist photochemisch nur mäßig reaktiv, da der Spacer zu lang ist.

Die Einführung von funktionellen Gruppen im Spacer beeinflußt das photochemische Verhalten des Chromophoren nur unwesentlich, wenn diese durch eine Alkylenoxygruppe voneinander getrennt sind. Die in der EP-A-279 475 genannten Benzophenonderivate des Typs

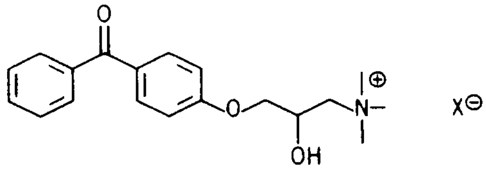

sind Beispiele dafür.

Nach dem oben angeführten Stand der Technik sollte also eine Ether- oder eine Estergruppe Bestandteil des Spacers sein (Schema II).

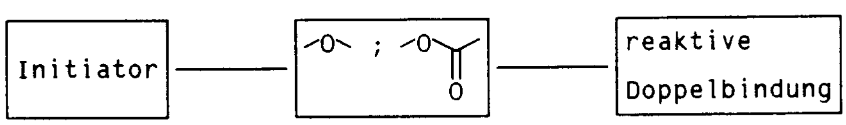


Schema II

Zu einem neuen Spacerschema gelangt man, indem man den Einfluß und die Funktion des Spacers als Substituenten auf das photochemisch angeregte Aceto- bzw. Benzophenonfragment betrachtet. So sind beispielsweise Spacer denkbar, die aufgrund ihrer Struktur stabilisierend oder destabilisierend wirken können.

Insbesondere die carbamoylsubstituierten Benzophenone des Typs

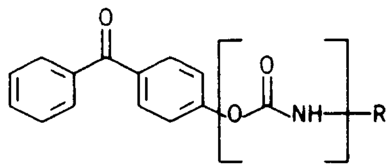

Schema III

stellen unter diesem Gesichtspunkt eine interessante Substanzklasse dar. In der US-PS 33 22 818 werden allyl- bzw. methallyl-substituierte Carbamoylbenzophenone beschrieben. Sie eignen sich aber nur als Fungizide (vgl. Schema IV).

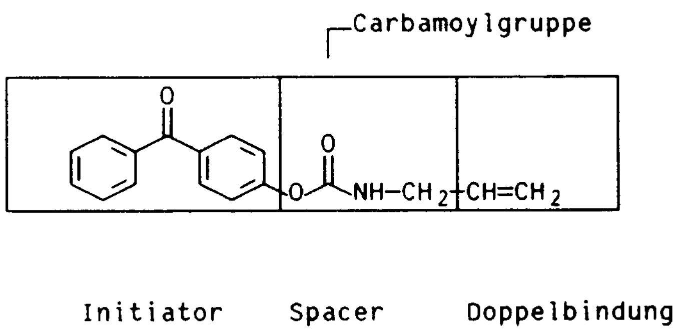


Schema IV

Für Copolymerisationen ist eine Allyl- bzw. Methallylgruppe nicht geeignet. Diese Benzoylphenyl-allylcarbamate haben daher im Polymerbereich keine praktische Bedeutung.

Neue, aber photochemisch wenig reaktive Monomere mit einem extrem langen Spacer werden in der GB-PS 2 100 722 beschrieben.

In der DE-A-3 820 463 werden schließlich Monomere des Typs (Schema V)

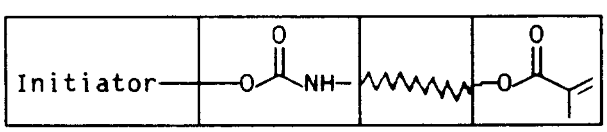


Schema V

beansprucht, die besonders reaktiv und bequem aus Hydroxyaromaten und (Meth)acryloylalkylisocyanaten zugänglich sind. Die notwendigen Isocyanate, wie z.B.

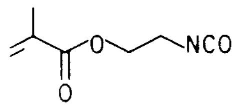

(IEM) oder

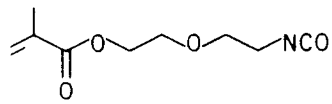

(IOPM),

sind jedoch sehr toxisch und aufwendig herzustellen.

Aufgabe der vorliegenden Erfindung ist es, strahlungsempfindliche, ethylenisch ungesättigte Phenonderivate, wie z.B. Aceto-, Benzophenon oder Thioxanthonderivate aufzuzeigen, die leicht zugänglich sind und einen auf den Photoinitiatorteil optimal abgestimmten Spacer beinhalten.

Es sind eine Reihe von Aceto- bzw. Benzophenoncarbonaten für unterschiedliche Einsatzbereiche bekannt.

Bei der Totalsynthese von Griseofulvin (A.C. Day et al., J.Chem.Soc. 1961, 4067) wird die Verbindung

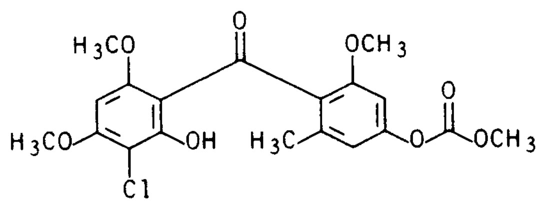

als Vorstufe eingesetzt. Weitere Beispiele für pharmakologisch interessante Carbonate des oben angegebenen Typs sind in J.Chem.Soc.C 1969, 1721; dito 1970, 392; Tetrahedron Lett. 1979, 4363 und NL-PS 7 008 636 beschrieben.

Als Herbizide wirken nach JP-OS 54-002323 und JP-OS 57-181001 die halogenierten Benzophenoncarbonate

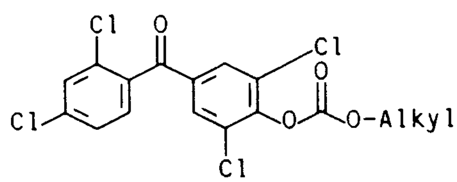

.

Führt man dagegen im Benzophenongrundkörper mindestens eine OH-Gruppe in o-Stellung zu $>C=O$ ein, dann gelangt man in die Klasse der UV-Stabilisatoren. Über die Carbonatgruppe werden - wie im folgenden Beispiel zu erkennen - häufig Chromophore

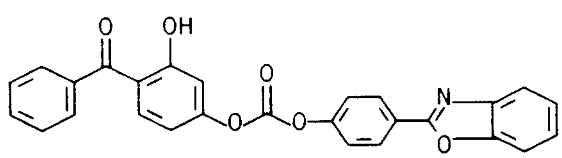

(vgl. US-PS 3 981 822, 4 115 348, 4 174 321) oder ein weiteres Strukturelement mit UV-absorbierenden Eigenschaften, wie in SU-PS 352 883, SU-PS 491 661 oder JP-OS 58-159460 und JP-OS 61-130 362 beschrieben, an das Benzophenon angehängt.

Zur Photopolymerisation werden schließlich die in der JP-OS 61-228007 aufgeführten, nicht copolymerisierbaren Benzildimethylketale

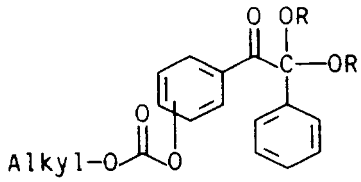

bzw. die Benzoinmonomethylether

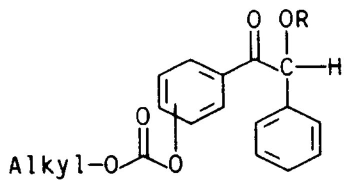

beansprucht.

Es sind also bisher nur Alkyl- und Aryl-substituierte Aceto- und Benzophenoncarbonate bekannt, die keine funktionelle Gruppe enthalten, die eine Copolymerisation ermöglicht.

Aufgabe der vorliegenden Erfindung ist es, copolymerisierbare Phenonderivate des Typs

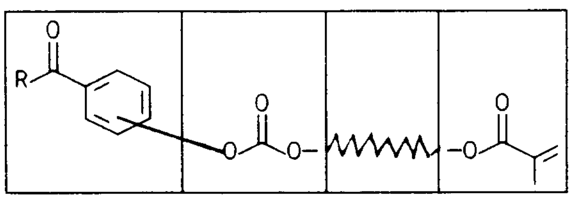

Schema VI

aufzuzeigen.

Gegenstand der Erfindung sind ethylenisch ungesättigte copolymerisierbare, strahlungsempfindliche organische Verbindungen der allgemeinen Formel (I),

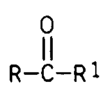

(I),

worin

R für einen geradkettigen Alkylrest mit 1 bis 4 Kohlenstoffatomen, vorzugsweise Methyl, Ethyl, n-Propyl, einen verzweigten, gegebenenfalls substituierten, Alkylrest mit 3 oder 4 Kohlenstoffatomen, wie iso-Propyl, sek.-Hydroxyisopropyl, sek.-Dimethylaminopropyl, sek.-Morpholinopropyl, tert.-Butyl, einen Arylrest, wie z.B. Phenyl, Tolyl oder Naphthyl, oder den Rest $R^1$ steht und

$R^1$ für den Rest

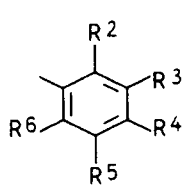

steht, wobei die Reste $R^2$ bis $R^6$ untereinander gleich oder verschieden sind und für H, Alkyl mit 1 bis 4 Kohlenstoffatomen, z.B. Methyl, Ethyl, n-Propyl, iso-Propyl, tert.-Butyl, Phenyl, OH, $OCH_3$, $OC_2H_5$, SH,

$SCH_3$, $SC_2H_5$, F, Cl, Br, CN, COOH, COOAlkyl mit Alkyl enthaltend 1 bis 17 Kohlenstoffatome, COOAryl, $CF_3$, $N(Alkyl)_2$, N(Alkyl)(Aryl), $N(Aryl)_2$, $N^{\oplus}(Alkyl)_3A^{\ominus}$, $N^{\oplus}H(Alkyl)_2A^{\ominus}$ mit Alkyl enthaltend 1 bis 4 Kohlenstoffatome und $A^{\ominus}$ für das Anion einer Säure, z.B. $Cl^{\ominus}$, $SO_4^{2\ominus}$, $PO_4^{3\ominus}$ Acetat$^{\ominus}$, $BF_4^{\ominus}$, $CF_3SO_3^{\ominus}$, $SbF_6^{\ominus}$, $AsF_6^{\ominus}$, $PF_6^{\ominus}$ stehen und mindestens einer aber maximal drei der Reste $R^2$ bis $R^6$ für den Rest

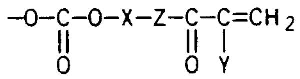 oder 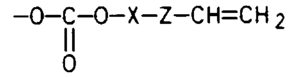

stehen, worin
X für einen zweiwertigen, gegebenenfalls substituierten Alkylenrest $-(CH_2)_m-$, einen Rest

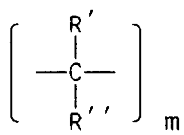 ,

mit m = 1 bis 10,
worin R' und R'' untereinander gleich oder verschieden sind und für Aryl, z.B. Phenyl, $C_1$- bis $C_4$-Alkyl, H, COOH, $COOCH_3$ oder $COOC_2H_5$ stehen, einen perfluorierten Alkylenrest $-(CF_2)_m-$ mit m = 1 bis 10, vorzugsweise ein Perfluorethylenrest, einen Oxaalkylenrest des Typs $-(CH_2)_n-O-(CH_2)_p-$ mit n = 1 bis 5 und p = 1 bis 5, vorzugsweise n = p = 2, d.h. $-C_2H_4-O-C_2H_4-$, einen perfluorierten Oxaalkylenrest des Typs $-(CF_2)_n-O-(CF_2)_p-$ mit n, p = 1 bis 5, beispielsweise Tetrafluorethylen, oder einen gegebenenfalls perfluorierten Polyoxaalkylenrest mit 2 bis 20 Sauerstoffatomen, die miteinander über mindestens eine $-CH_2-$, $-CF_2-$ oder $-CH_2-CH(CH_3)-$Gruppe verbunden sind, für einen Alkylenrest des Typs $-(CH_2)_m-O-CO-O(CH_2)_n-$, $-(CH_2)_n-O-CO-NH-(CH_2)_m-$, $-(CH_2)_n-NH-CO-O-(CH_2)_m-$, $-(CH_2)_m-CO-O-(CH_2)_n-$ oder $-(CH_2)_m-O-CO-(CH_2)_n-$mit m = 1 bis 10, n = 1 bis 10, einen gegebenenfalls mit Alkyl mit 1 bis 4 Kohlenstoffatomen, z.B. Methyl, Ethyl, n-Propyl, iso-Propyl, OH, $OCH_3$, $OC_2H_5$, SH, $SCH_3$, $SC_2H_5$, Cl, F, $N(Alkyl)_2$ oder $N(CH_3)C_6H_5$ in o-, m- und/oder p-Stellung substituierten Phenylen-, oder einen Cycloalkylenrest mit 5 bis 10 Kohlenstoff-Atomen, z.B. Cyclohexylen-, Cyclooctylen-, für einen (Bis)methylencycloalkylenrest mit 6 bis 12 Kohlenstoffatomen,
Y für H, Alkyl mit 1 bis 6 Kohlenstoffatomen oder Phenyl,
Z für O, NY stehen,
oder für den Fall, daß R für einen Arylrest steht, einer der Reste $R^2$ oder $R^6$ für ein Schwefelatom stehen kann, durch das der Arylrest R in ortho-Position mit $R^1$ verbunden ist und beispielsweise einen Thioxanthonyl-rest ergibt.

Überraschenderweise zeigen die erfindungsgemäßen Verbindungen eine besonders hohe photochemische Reaktivität im kurz- bis längerwelligen UV-Bereich von 254 bis 400 nm, sowie eine gute Lagerstabilität.

Eine weitere Aufgabe der vorliegenden Erfindung bestand darin, ein Verfahren zur Herstellung neuartiger strahlungsempfindlicher Aceto-, Benzophenon- und Thioxanthoncarbonate mit mindestens einer Acrylat- bzw. Methacrylatendgruppe aufzuzeigen.

Die Synthese von Arylcarbonaten ohne copolymerisationsfähige Endgruppe ist bekannt (JP-OS 59-001 438, JP-OS 59-170 033). Eine gute Übersicht geben: a) Houben-Weyl, Methoden der Organischen Chemie, Bd. 8, S. 75, 101-107, Thieme-Verlag 1952, b) Kirk-Othmer, Encyclopedia of Chemical Technology, Bd. 4, S. 758-771, John Wiley 1978 und c) Ullmann's Encyclopedia of Industrial Chemistry, Bd. A5, S. 197-202, Verlag Chemie 1986.

Das wichtigste Darstellungsverfahren für Carbonate ist die Umsetzung von Kohlensäureesterchloriden mit Alkoholen. Die Prozedur ist ausführlich in Houben-Weyl, Bd. 8 (s.o.) und in der DE-PS 1 080 546 sowie in J.Org.Chem. 26, 5119 (1961) beschrieben. Die Kohlensäureester entstehen in guten bis sehr guten Ausbeuten, wenn der Alkohol und der Chlorkohlensäureester im Molverhältnis 1:1 ohne Solvens oder in überschüssigem Alkohol als Lösungsmittel miteinander zur Reaktion gebracht werden. In den Fällen, in denen der Alkohol bzw. das Phenol und/oder der Chlorkohlensäureester als Feststoff vorliegen, verwendet man aprotische Lösungsmittel, wie z.B. Dichlormethan, Dichlorethan, Acetonitril, Toluol, Xylol usw.

Für die Synthese der im Anspruch 1 genannten Verbindungen stehen prinzipiell zwei Wege offen (Schema VII):

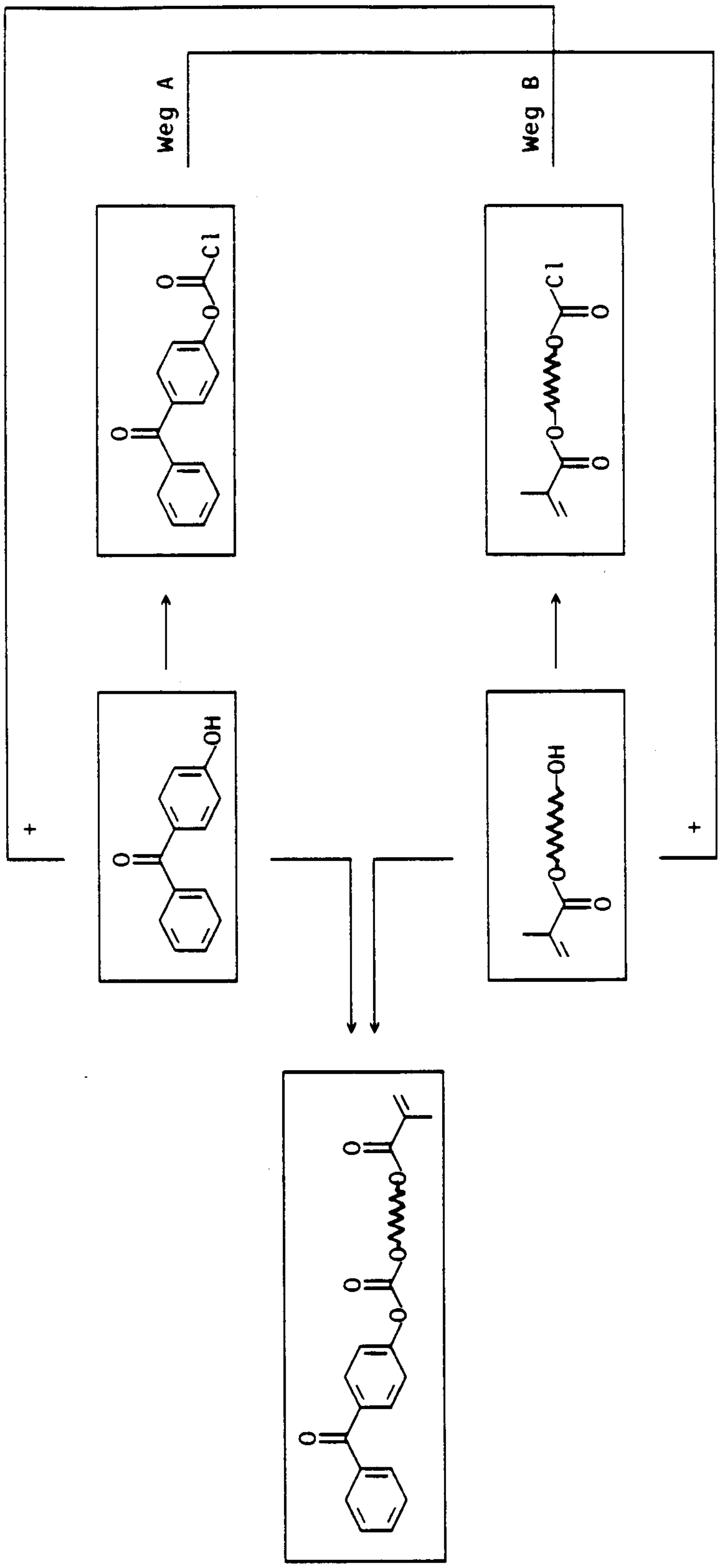


Schema VII

Die als Ausgangsmaterial benötigten Hydroxyacetophenone und Hydroxybenzophenone sind nach bekannten Verfahren herstellbar. So erhält man beispielsweise 4-Hydroxybenzophenon in ca. 90 %iger Ausbeute durch Friedel-Crafts-Acylierung von Phenol mit Benzoylchlorid in Nitrobenzol in Gegenwart von $AlCl_3$ oder $TiCl_4$ (Houben-Weyl 7/2a, S. 186) oder isomerenfrei durch Oxidation von 4-Hydroxy-diphenylmethan mit 5,6-Dichlor-2,3-dicyan-p-benzochinon (Houben-Weyl 7/2a, S. 681).

Die Synthesen der aminosubstituierten Benzophenone, wie z.B. 2-Benzyl-2-(dimethylamino)-1-(4-hydroxyphenyl)-butan-1-on oder 1-(4-Hydroxyphenyl)-2-methyl-2-morpholino-propan-1-on sind in EP-A-284 561 und EP-A-117 233 beschrieben.

Das 2-Hydroxythioxanthon kann nach dem in den GB-PS 2 108 487 (1981) und GB-PS 2 108 979 (1982) beschriebenen Verfahren aus Thiosalicylsäure und Phenol dargestellt werden.

Die aromatischen Chlorformiate (vgl. J.Prakt.Chem. 313, 331 (1971), dito 317, 62, 73, 81 (1975)) der allgemeinen Formel (IIIb) lassen sich aus einem substituierten Phenol, z.B. 4-Chlor-5'-fluor-2'-hydroxybenzophenon, 4-Chlor-4'-hydroxybenzophenon, 2,4-Dihydroxybenzophenon, 4,4'-Dihydroxybenzophenon, 4-Fluor-4'-hydroxybenzophenon, 2-Hydroxybenzophenon, 4-Hydroxybenzophenon, 2-Hydroxy-4-methoxybenzophenon, 2, 3, 4-Trihydroxybenzophenon, 2-Hydroxy-thioxanthon, 3-Hydroxy-thioxanthon, (4-Hydroxyphenyl)-2-hydroxy-2-propylketon (DE-OS 35 34 645) durch Phosgenierung nach literaturbekannten Standardverfahren mit Phosgen, s. z.B. Houben-Weyl, Methoden der Organischen Chemie, Bd. 8, Thieme-Verlag 1952, Trichlormethylchlorformat (Diphosgen), J.Prakt.Chem. 126, 210 (1930), dito 128, 233 (1930), Chem.Abstr. 95, 81766, J.Org.Chem. 50, 715 (1985), J.Org.Chem. 41, 2070 (1976), Angew. Chem. 89, 267 (1977), dem kristallinen Triphosgen, Angew. Chem. 99, 922 (1987), N,N'-Carbonyldiimidazol oder N,N'-Carbonyldi-s-triazol (Fieser 1, 116 (1967)), in guten Ausbeuten herstellen.

Über den Einsatz alternativer Verfahren für die Phosgenierung, z.B. die Umsetzung mit Chlorkohlensäureestern gibt "Merck Kontakte" 1981 (1), 14-18 Auskunft.

Die Hydroxyalkylen(meth)acrylate und Hydroxyalkylen(meth)acrylamide entstehen durch Acylierung oder Veresterung geeigneter $\alpha,\omega$-Alkandiole bzw. Aminoalkohole, wie z.B. 1,2-Ethan-, 1,3-Propan-, 1,2-Butan-, 1,4-Butan-, 1,5-Pentan-, 1,6-Hexandiol-, 1,4-Cyclohexandiol, 1,2-Cyclohexandiol, Ethanolamin, p-Hydroxyanilin oder Diole, wie Polytetrahydrofuran, Polyethylenoxid, Polypropylenoxid mit Säurechloriden, Estern oder Anhydriden der Acryl- und Methacrylsäure. Von besonderem Interesse ist die Umesterungsreaktion. Für die Umesterung werden beispielsweise Acrylsäuremethylester, Acrylsäureethylester, Acrylsäure-n-butylester, Methacrylsäuremethylester, -ethylester, -propylester, -n-butylester und -t-butylester verwendet. Von besonderem Interesse ist Methacrylsäuremethylester. Bei der praktischen Durchführung des Verfahrens kann der Acryl- oder Methacrylester im Unterschuß oder vorzugsweise im Überschuß eingesetzt werden. Im allgemeinen setzt man, bezogen auf das Diol die 1 bis 1,5fache molare Menge des Acryl-oder Methacrylsäureesters ein, wobei ein Überschuß von der 1,5fachen bis zur 5fachen Menge besonders zu vermeiden ist, um den Anteil an Diacrylat minimal zu halten. Zusätzlich kann das Reaktionsgemisch auch noch Lösungsmittel, z.B. Benzol, Toluol, Xylol, Chlorbenzol, Dioxan, Cyclohexan, n-Heptan, n-Octan, n-Nonan oder n-Decan enthalten. Bevorzugt arbeitet man in Abwesenheit von Lösungsmitteln.

Im allgemeinen verwendet man bei der Umesterungsstufe einen für Umesterungen üblichen Katalysator. Als solche kommen z.B. Alkalialkoholate, wie Natriummethylat, -ethylat, -propylat, Lithiummethylat und vorzugsweise Verbindungen von Titan, Zinn und Zirkon in Betracht. Beispielhaft genannt seien Titantetramethylat, -tetraethylat, -tetrapropylat, -tetrabutylat, Dibutylzinnoxid, Dibutylzinndilaurat, Dimethoxydibutylzinn und Zirkoniumpentan-2,4-dionat.

Die Mengen der Katalysatoren liegen häufig im Bereich von 0,0005 bis 0,5 mol, vorzugsweise von 0,001 bis 0,02 mol Katalysator je Mol Diol. Bei der Umesterung arbeitet man im allgemeinen bei Temperaturen von 50 bis 150 °C, vorzugsweise von 80 bis 120 °C unter Sieden des Reaktionsgemisches, wobei das bei der Umesterung freigesetzte Alkanol gegebenenfalls zusammen mit einem Anteil des Acrylsäureesters oder Methacrylsäureesters als Azeotrop aus dem Reaktionsgemisch abdestilliert wird.

Nach Durchführung der Umesterungsreaktion können der überschüssige Acryl-oder Methacrylester und gegebenenfalls Lösungsmittel z.B. durch Destillation, vorzugsweise unter vermindertem Druck, vom Reaktionsgemisch abgetrennt werden. Soweit gewünscht, kann der erhaltene Monohydroxyalkylen-(meth)-acrylsäureester z.B. durch Destillation unter vermindertem Druck, durch Extraktion oder durch Kristallisation gereinigt werden. Man kann jedoch auch das Reaktionsprodukt der Umesterungsstufe ohne weitere Reinigung oder gegebenenfalls nach Abtrennung des Katalysators bzw. seines Salzes durch Hydrolyse und Filtration der nächsten Stufe des Verfahrens zuführen.

Bei Durchführung der Acylierung mit (Meth)acrylsäureanhydrid setzt man die Edukte bevorzugt stöchiometrisch ein. Man arbeitet im allgemeinen bei Temperaturen von 80 bis 140 °C, vorzugsweise von 90 bis 110 °C. Als Katalysatoren kommen vor allem Säuren, insbesondere konzentrierte Schwefelsäure in Betracht, die in Mengen von 0,1 bis 2 Mol% verwendet werden. Nach Abtrennen von Katalysator und (Meth)-acrylsäure z.B. durch Neutralisieren mit wäßrigen Basen, z.B. Natriumcarbonatlösung oder verdünnter Natronlauge, kann das Rohprodukt, gegebenenfalls nach Trocknung z.B. mit Natriumsulfat oder Magnesiumsulfat, ohne weitere Reinigung in der nächsten Stufe eingesetzt werden.

Um eine vorzeitige Polymerisation der $\alpha,\beta$-monoolefinisch ungesättigten Reaktionsteilnehmer zu verhindern, setzt man dem Reaktionsgemisch vorzugsweise einen üblichen Stabilisator zu. Als solche kommen

z.B. Hydrochinon, Hydrochinonmonomethylether, 2,6-Di-tert.-butyl-4-methylphenol, para-Nitrosophenol und/oder Phenothiazin in Betracht. Darüberhinaus hat es sich als äußerst vorteilhaft erwiesen, während der Acylierung Sauerstoff oder Luft durch das Reaktionsgemisch zu leiten.

Die Hydroxyalkyl- bzw. -alkylenmonovinylether sind in guten Ausbeuten nach dem in Liebigs Ann. Chem. 601, 81 (1956) beschriebenen verfahren gut zugänglich.

Die folgenden erfindungsgemäß verwendbaren (Meth)acrylate, (Meth)acrylamide und Hydroxyalkylvinylether seien beispielhaft genannt:

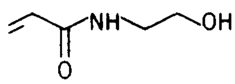

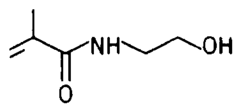

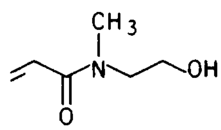

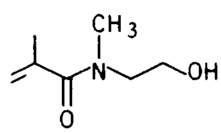

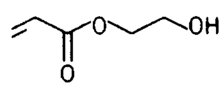

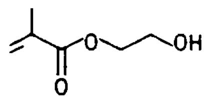

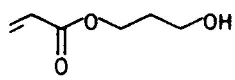

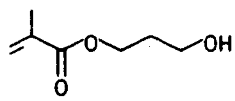

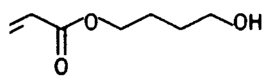

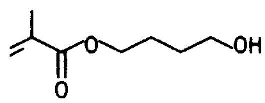

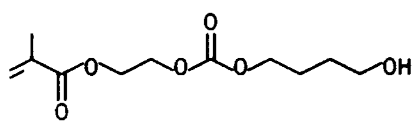

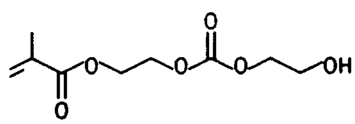

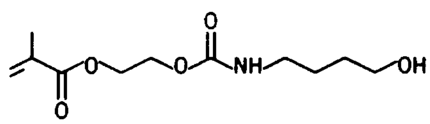

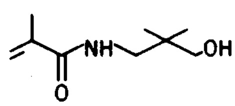

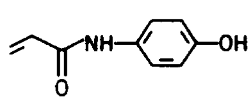

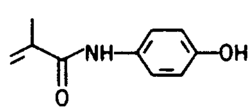

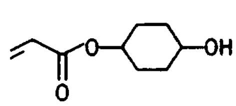

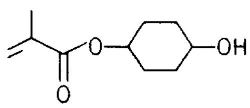

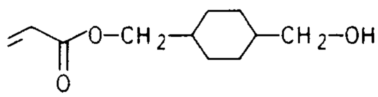

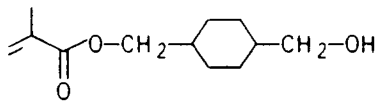

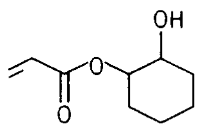

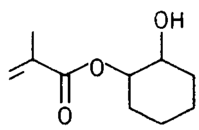

vgl. auch CA 86, 107063a (Deposited Doc. 1974, VINITI 2065-74)

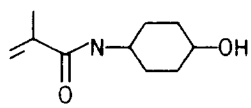

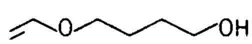

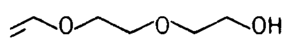

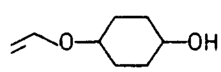

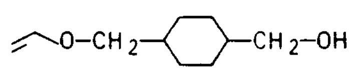

Für die Umsetzung der Hydroxyaceto-, -benzophenone bzw. -thioxanthone werden im allgemeinen die entsprechenden ω-(Meth)acryloyloxyalkyl-chloroformiate benötigt. Diese sind nach literaturbekannten Verfahren, wie z.B. in Eur. Polym. J. 14, 205 (1978); J.Polym.Sci.Polym.Symp. 66, 41 (1979); Bull.Soc.Chim. Belg. 93, 159 (1984) beschrieben, bequem und in guten Ausbeuten darstellbar.

Überraschend wurde gefunden, daß die erfindungsgemäßen Aceto- und Benzophenon-sowie Thioxanthonderivate auf den im Schema VII angegebenen Wegen A und B leicht und in sehr guter Ausbeute zugänglich sind. Dies ist insbesondere im Hinblick auf die Reaktivität und Bifunktionalität der (Meth)acrylat- bzw. Vinyletherkomponente unerwartet, da eine Vielzahl verschiedener Reaktionsprodukte denkbar ist. Die Wege A und B unterscheiden sich insbesondere auch von der in der DE-A-3 820 463 beschriebenen Variante, bei der unter neutralen Bedingungen schwer zugängliche und toxische Isocyanate eingesetzt werden.

Die Wege A und B sind ökonomischer, effizienter und im Hinblick auf die Bifunktionalität der Einsatzstoffe neuartig gegenüber dem Stand der Technik (vgl. Houben-Weyl, Bd. 8, S. 75, 101-107).

Gegenstand der vorliegenden Erfindung ist außerdem ein Verfahren zur Herstellung von Verbindungen der allgemeinen Formel (I), wobei man eine Verbindung der Formel (IIa) oder (IIb)

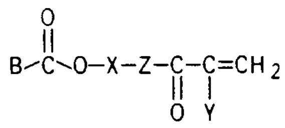 oder 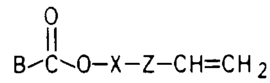 ,

(IIa) (IIb)

worin
X, Y und Z die obengenannte Bedeutung haben und
B für eine der Gruppen Tosylat, Alkoxy mit 1 bis 5 Kohlenstoffatomen, Halogen, wie z.B. Cl, Br, Chlorcarbonyl, Imidazolyl, Pyrazolyl, Ammonium-, Pyridinium-, Phosphonium-, Sulfoniumkation steht - vorzugsweise wären dies z.B. 2-(Acryloyloxyethyl)-, 2-(Methacryloyloxyethyl)chlorkohlensäureester, 2-(Methacryloyloxyethyl)chlorglyoxylsäureester, (2-(Meth)acryloyloxyethyl)-methyl-carbonat - mit einer Verbindung der allgemeinen Formel (IIIa)

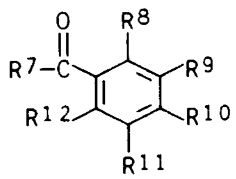 (IIIa),

worin
$R^7$ für einen geradkettigen Alkylrest mit 1 bis 4 Kohlenstoffatomen, einen verzweigten, gegebenenfalls substituierten, Alkylrest mit 3 oder 4 Kohlenstoffatomen, für einen Arylrest oder den Rest $R^1$ steht und worin die Reste
$R^8$ bis $R^{12}$ untereinander gleich oder verschieden sind und für H, Alkyl mit 1 bis 4 Kohlenstoffatomen, Phenyl, OH, $OCH_3$, $OC_2H_5$, SH, $SCH_3$, $SC_2H_5$, F, Cl, Br, CN, COOH, COOAlkyl mit Alkyl enthaltend 1 bis 17 Kohlenstoffatome, COOAryl, $CF_3$, $N(Alkyl)_2$, N(Alkyl)(Aryl), $N(Aryl)_2$, $N^{\oplus}(Alkyl)_3A^{\ominus}$, $N^{\oplus}H(Alkyl)_2A^{\ominus}$ mit Alkyl, enthaltend 1 bis 4 Kohlenstoffatome, und $A^{\ominus}$ für das Anion einer Säure, z.B. $Cl^{\ominus}$, $SO_4^{2\ominus}$, $PO_4^{3\ominus}$, $Acetat^{\ominus}$, $BF_4^{\ominus}$, $CF_3SO_3^{\ominus}$, $AsF_6^{\ominus}$, $SbF_6^{\ominus}$, $PF_6^{\ominus}$ usw. stehen oder einer der Reste $R^8$ oder $R^{12}$ für ein Schwefelatom stehen kann, durch das der Arylrest in ortho-Position mit $R^7$ verbunden ist, mit der Maßgabe, daß mindestens einer der Reste $R^8$ bis $R^{12}$ für eine Hydroxylgruppe steht, im äquimolaren Verhältnis (mit gegebenenfalls bis zu 20 %igem Überschuß) oder entsprechend der Anzahl der Hydroxylgruppen in den Resten $R^8$ bis $R^{12}$ dem Zwei- oder Dreifachen davon, gegebenenfalls in Gegenwart eines inerten Lösungsmittels oder Lösungsmittelgemisches und eines basischen Katalysators, bei Temperaturen von 0 bis 100 °C unter wasserfreien Bedingungen umsetzt (Weg B).

Gegenstand der vorliegenden Erfindung ist weiterhin ein Verfahren zur Herstellung von Verbindungen der allgemeinen Formel (I), wobei man eine Verbindung der Formel (IVa) oder (IVb)

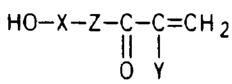 oder $HO-X-Z-CH=CH_2$ ,

(IVa) (IVb)

worin
X, Y und Z die in Anspruch 1 angegebene Bedeutung haben, vorzugsweise sind dies die oben beispielhaft angegebenen (Meth)acrylate, Methacrylamide oder Hydroxyalkylvinylether, mit einer Verbindung der allgemeinen Formel (IIIb),

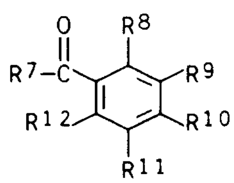 (IIIb),

worin

$R^7$ für einen geradkettigen Alkylrest mit 1 bis 4 Kohlenstoffatomen, vorzugsweise Methyl, Ethyl, n-Propyl, einen verzweigten, gegebenenfalls substituierten, Alkylrest mit 3 oder 4 Kohlenstoffatomen, wie i-Propyl, sek.-Hydroxyisopropyl, sek.-Dimethylaminopropyl, sek.-Morpholinopropyl, tert.-Butyl, oder einen Arylrest, z.B. Phenyl, Tolyl oder Naphthyl, vorzugsweise Phenyl steht und worin die Reste

$R^8$ bis $R^{12}$ untereinander gleich oder verschieden sind und für H, Alkyl mit 1 bis 4 Kohlenstoffatomen, z.B. Methyl, Ethyl, n-Propyl, iso-Propyl, tert.-Butyl, Phenyl, OH, $OCH_3$, $OC_2H_5$, SH, $SCH_3$, $SC_2H_5$, F, Cl, Br, CN, COOH, COOAlkyl mit Alkyl enthaltend 1 bis 17 Kohlenstoffatome, COOAryl, $CF_3$, $N(Alkyl)_2$, N(Alkyl)(Aryl), $N(Aryl)_2$, $N^{\oplus}(Alkyl)_3A^{\ominus}$, $N^{\oplus}H(Alkyl)_2A^{\ominus}$ mit Alkyl enthaltend 1 bis 4 Kohlenstoffatome und $A^{\ominus}$ für das Anion einer Säure, z.B. $Cl^{\ominus}$, $SO_4^{2\ominus}$, $PO_4^{3\ominus}$, $Acetat^{\ominus}$, $BF_4^{\ominus}$, $CF_3SO_3^{\ominus}$, $AsF_6^{\ominus}$,$SbF_6^{\ominus}$, $PF_6^{\ominus}$ usw. stehen oder einer der Reste $R^8$ oder $R^{12}$ für ein Schwefelatom steht, durch das der Arylrest in ortho-Position mit $R^7$ verbunden ist, mit der Maßgabe, daß mindestens einer der Reste $R^8$ bis $R^{12}$ für eine Gruppe des Typs B-CO-O, worin B die in den Formeln (IIa) und (IIb) angegebene Bedeutung hat, steht, beispielsweise

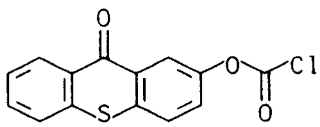

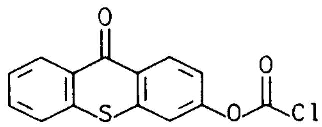

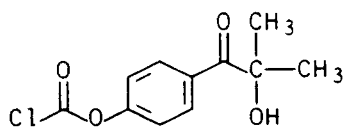

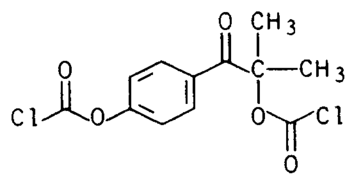

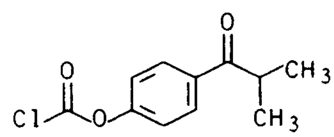

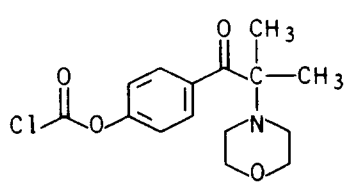

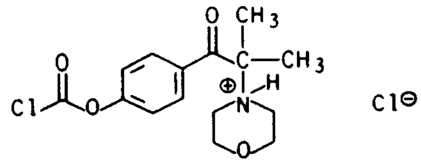

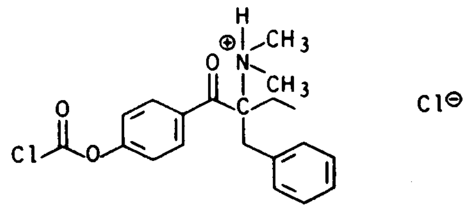

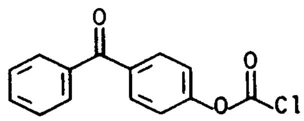

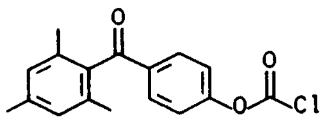

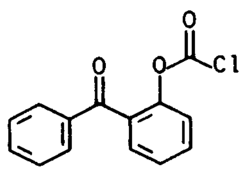

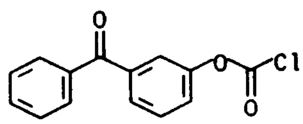

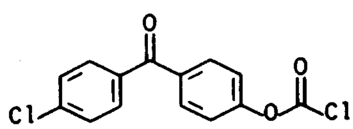

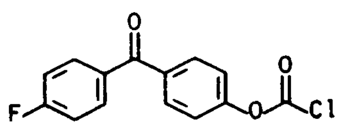

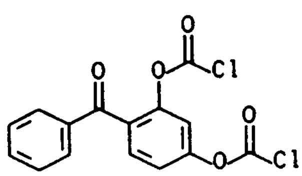

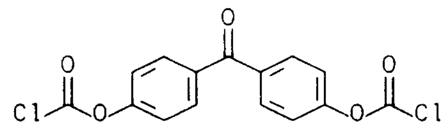

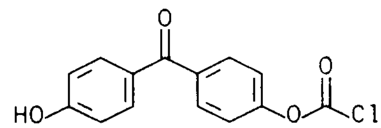

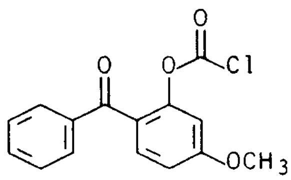

im äquimolaren Verhältnis (gegebenenfalls mit bis zu 10 bis 30 %igem Überschuß) oder entsprechend der Anzahl der Gruppen B-CO-O in den Resten $R^8$ bis $R^{12}$ dem Zwei- oder Dreifachen davon unter Feuchtigkeitsausschluß, gegebenenfalls in Gegenwart eines inerten Lösungsmittels oder Lösungsmittelgemisches und eines basischen Katalysators, bei Temperaturen von 0 bis 100 °C, vorzugsweise bei 20 bis 50 °C, miteinander umsetzt (Weg A).

Zum Herstellverfahren ist im einzelnen Folgendes auszuführen.

Die bei der Reaktion eingesetzten Chlorformiate reagieren leicht mit Nucleophilen, u.a. auch mit Wasser. Deshalb ist bei der Reaktion auf Feuchtigkeitsausschluß durch Verwendung getrockneter nicht nucleophiler Lösungsmittel, wie z.B. Acetonitril, Dichlormethan, Dichlorethan, THF, Toluol, Xylol, Chlorbenzol, Essigester, Chloroform usw. und gegebenenfalls auf den Aufbau einer Inertgasatmosphäre, z.B. Stickstoff, Argon oder Kohlendioxid zu achten.

In der Regel wird eine Lösung oder Suspension der Hydroxyverbindung in einem inerten Lösungsmittel, welches auch wegfallen kann, wenn die Verbindung bei der Reaktionstemperatur flüssig ist, bei Temperaturen von 0 bis 100 °C, vorzugsweise bei 10 bis 50 °C, in Gegenwart eines basischen, nicht nucleophilen Amins, vorzugsweise Triethylamin, 4-Dimethylaminopyridin, Imidazol, 1,4-Diazabicyclo[2.2.2]octan, 1,5-Diazabicyclo[4.3.0]-non-5-en, 1,8-Diazabicyclo[5.4.0]undec-7-en, Polyvinylpyridin, N,N'-Dimethylpropylenharnstoff, N,N'-Dimethylethylenharnstoff usw., vorgelegt. Dann wird die Chlorformylverbindung, u.U. gelöst in einem inerten Lösungsmittel, wie z.B. Dichlormethan, Dichlorethan, Acetonitril, Toluol, Chlorbenzol, Xylol usw. unter Rühren im oben angegebenen Temperaturbereich zugetropft. Diese Arbeitsweise eignet sich besonders für größere Ansätze.

Nach einer Nachrührzeit von 1 bis 48 Stunden, vorzugsweise 1 bis 20 Stunden bei 10 bis 40 °C wird nach Standardverfahren filtriert, gewaschen, getrocknet und das Produkt nach dem Umkristallisieren, Destillieren oder Extrahieren isoliert.

Die erfindungsgemäß funktionalisierten Acetophenone, Benzophenone und Thioxanthone eignen sich als polymerisierbare oder mit ungesättigten Verbindungen copolymerisierbare Photoinitiatoren für strahlungshärtbare Zusammensetzungen.

Überraschenderweise wurde gefunden, daß die mit der Carbonatgruppe ausgerüsteten Photoinitiatoren ab einer bestimmten Spacerlänge nach photochemischer Anregung reaktiver sind als die beispielsweise in der DE-A-37 38 567 beschriebenen Derivate. Im Gegensatz zu den in DE-A-38 20 463 beschriebenen Carbamoylderivaten neigen die Carbonate im bestrahlten Polymeren nicht zur Vergilbung, sie sind völlig geruchlos und universell einsetzbar, weil sie mit vielen Bindemitteln und Bindemittelsystemen gut verträglich sind.

Für alle in den folgenden Beispielen angegebenen Verbindungen wurde die Struktur z.T. durch unabhängige Synthesen und in allen Fällen durch korrekte $^1$H-NMR-, IR- und Massenspektren sowie durch übereinstimmende Elementaranalysen bestätigt.

Beispiel 1

4-Chlorformylbenzophenon

In eine Lösung von 4 kg 4-Hydroxybenzophenon und 190 g Benzyltrimethylammoniumchlorld in 11,4 kg o-Xylol wurden in 5 Stunden insgesamt 3,4 kg Phosgen eingeleitet. Die Innentemperatur wurde während dieser Zeit von 95 auf 120 °C erhöht. Nach Beendigung der Phosgeneinleitung wurde 30 Minuten bei 115 °C nachgerührt. Zur Aufarbeitung wurde der Phosgenüberschuß mit Stickstoff ausgetrieben. Das gegen Ende der Reaktion ausgefallene Salz (Katalysator) wurde abfiltriert und das Lösungsmittel abdestilliert. Man erhielt 4,9 kg (93 %) gelblich gefärbtes 4-Chlorformylbenzophenon vom Schmp. 67-72 °C. Dieses Rohprodukt mit $Cl^-$-Wert = 12,69 % (theor. 13,60 %) wurde direkt ohne weitere Reinigung für die Folgereaktionen verwendet.

In Analogie zu der im Beispiel 1 genannten Vorschrift wurden die folgenden Chlorformylverbindungen hergestellt:

Beispiel 2

Aus 2-Hydroxythioxanthon wurden in 79 % Ausbeute 2-Chlorformyl-thioxanthon (Cl: Ber. = 12,19 %; Gef. = 12,03 %) erhalten.

Beispiel 3

3-Chlorformylthioxanthon war in 63 % Ausbeute aus 3-Hydroxythioxanthon (Cl: Ber. = 12,19 %; Gef. = 11,22 %) zugänglich.

Beispiel 4

Aus (4-Hydroxyphenyl)-(2-hydroxy-2-propyl)keton wurden in 75 %iger Ausbeute (4-Chlorformylphenyl)-(2-hydroxy-2-propyl)keton als Rohprodukt (Cl: Ber. = 14,61 %; Gef. = 13,07 %) erhalten.

Beispiel 5

Aus 1-(4-Hydroxyphenyl)-2-methyl-2-morpholinopropan-1-on wurde durch Phosgenierung zunächst das Hydrochlorid erhalten, welches nach vorsichtigem Versetzen mit 1,5-Diazabicyclo[4.3.0]non-5-en in das freie Amin überführt werden konnte; Ausbeute: 62 % (Cl: Ber. = 11.37 %; Gef. = 11.21 %).

Beispiel 6

4,4'-Benzoylphenyl-ethyl-carbonat

Zu einer Lösung von 0,25 kg Ethanol und 0,53 kg Triethylamin in 1,33 kg Tetrahydrofuran wurden bei Raumtemperatur 1,3 kg 4-Chlorformylbenzophenon in 2,2 kg Tetrahydrofuran zugetropft. Nach 1stündigem Kochen am Rückfluß wurde auf 25-30 °C abgekühlt und in 20 kg Eiswasser eingerührt. Die wäßrige Phase wurde dreimal mit Dichlormethan extrahiert und die organische Phase nach dem Trocknen über Natriumsulfat im Vakuum eingeengt. Der Rückstand wurde aus Methanol umkristallisiert. Ausbeute: 1,05 kg (78 %) helle Kristalle vom Schmp.121-122 °C.

Das 4,4'-Benzoylphenyl-ethyl-carbonat war mit authentischem Material (Can.J.Chem. 56, 1031 (1978)) identisch.

Beispiele 7 bis 18

In Analogie zu der im Beispiel 6 angegebenen Vorschrift wurden die folgenden unsymmetrischen Carbonate hergestellt.

| Nr. | Verbindung | Ausbeute [%] |
|---|---|---|
| 7 | 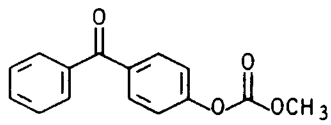 | 83 |
| 8 | 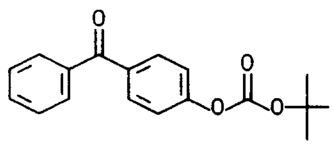 | 58 |
| 9 | 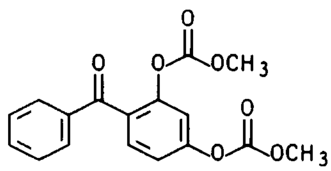 | 65 |
| 10 | 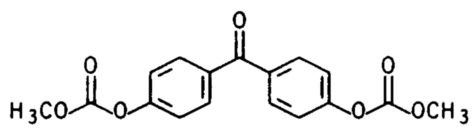 | 67 |
| 11 | 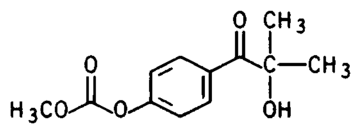 | 75 |
| 12 | 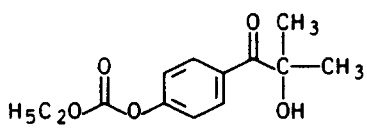 | 69 |
| 13 | 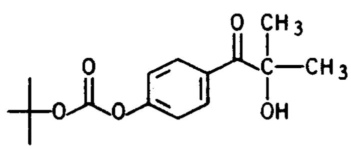 | 52 |
| 14 | 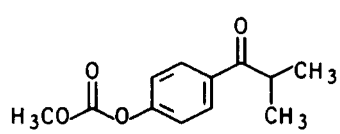 | 88 |
| 15 | 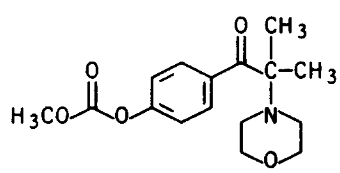 | 73 |

| Nr. | Verbindung | Ausbeute [%] |
|---|---|---|
| 16 | 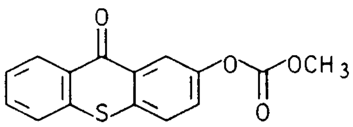 | 72 |
| 17 | 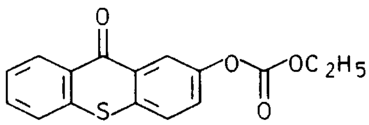 | 77 |
| 18 | 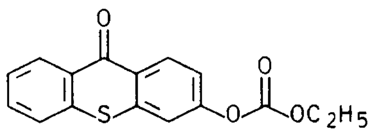 | 70 |

Beispiel 19

α,ω-Acryloylbutylen-(4,4'-benzoylphenyl)-carbonat

Zu der Lösung von 7,2 kg Butandiolmonoacrylat und 5,3 kg Triethylamin in 17 kg Toluol wurden bei 25 bis 30 °C 13,0 kg 4-Chlorformyl-benzophenon in 22 kg Toluol zugetropft. Nach zweistündigem Nachrühren bei Raumtemperatur wurde nacheinander mit Wasser, Natriumhydrogencarbonatlösung und wieder mit Wasser gewaschen. Die organische Phase wurde über Natriumsulfat getrocknet und im Wasserstrahlvakuum eingeengt. Es wurden 17,9 kg (97 %) einer gelblichen, viskosen Flüssigkeit isoliert, die dünnschichtchromatographisch einheitlich war.

Beispiel 20

In der Lösung von 0,5 kg Triethylamin in 4,3 kg Toluol wurden 0,91 kg 2-Hydroxythioxanthon suspendiert und zu dieser Mischung bei 20 bis 24 °C eine Lösung von 0,81 kg 2-Chlorformyl-ethylmethacrylat zu 1,7 kg Toluol langsam zugetropft. Nach Zusatz von 0,002 kg Phenothiazin wurde 18 Stunden bei Raumtemperatur nachgerührt. Die organische Phase wurde dann mit Wasser, Natriumhydrogencarbonat-Lösung und wieder mit Wasser gewaschen. Nach dem Trocknen über Natriumsulfat und Einengen im Wasserstrahlvakuum wurde der Rückstand aus Isopropanol umkristallisiert.

Ausbeute: 0,97 kg (63 %) gelbe Kristalle vom Schmp. 72-76 °C.

Beispiele 21 bis 34

In Analogie zu den in den Beispielen 19 bzw. 20 ausführlich beschriebenen Verfahren wurden die folgenden Verbindungen synthetisiert:

| Nr. | Verbindung | Ausbeute [%] |
|---|---|---|
| 21 | 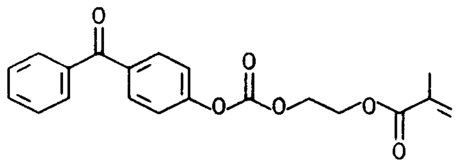 | 89 |
| 22 | 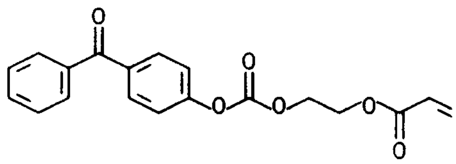 | 94 |
| 23 | 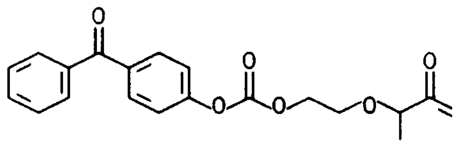 | 95 |
| 24 | 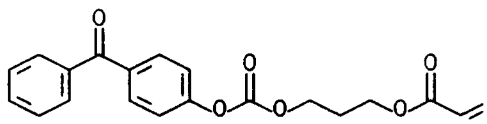 | 49 |
| 25 | 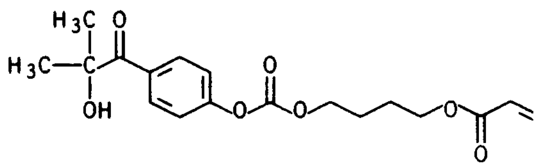 | 64 |
| 26 | 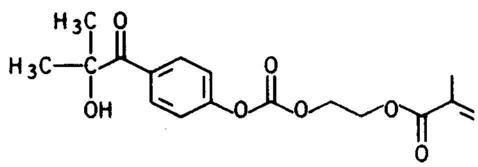 | 71 |
| 27 | 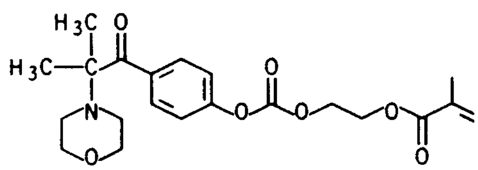 | 76 |
| 28 | 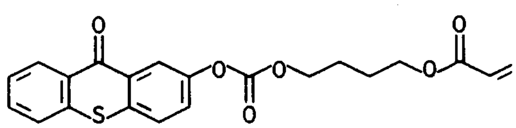 | 58 |

| Nr. | Verbindung | Ausbeute [%] |
|---|---|---|
| 29 | 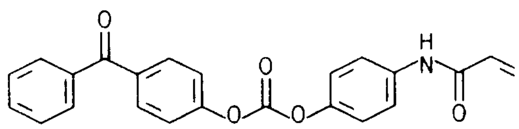 | 73 |
| 30 | 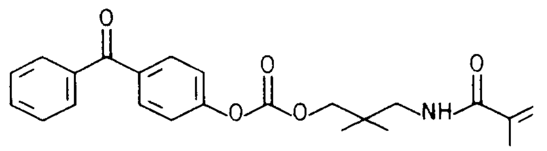 | 97 |
| 31 | 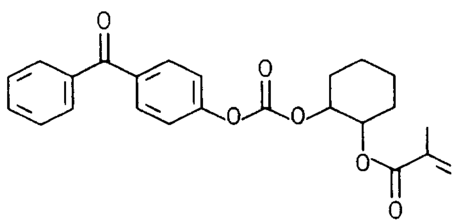 | 42 |
| 32 | 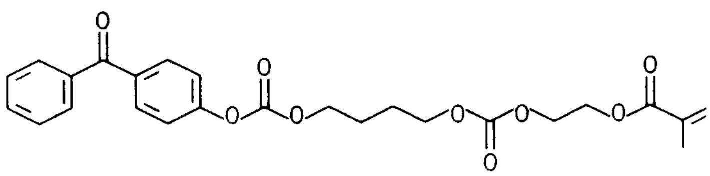 | 88 |
| 33 | 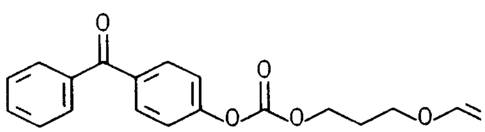 | 79 |
| 34 | 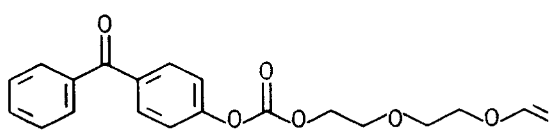 | 82 |

Beispiele 35 bis 53

Anwendung der Aceto-, Benzophenon- und Thioxanthonderivate als Photoinitiatoren

In einem Modellpolymeren aus 62 Gew.% eines bifunktionellen Epoxidacrylats (Acrylat, abgeleitet vom Bisphenolglycidylether), 35 Gew.% Hexandioldiacrylat und 3 Gew.% Butanol (Viskositätseinstellung, Filmbildung) werden 0,1 bis 0,3 g des zu prüfenden Photoinitiators zusammen mit 0,2 bis 0,3 g Amin und gegebenenfalls einem Sensibilisator gelöst und 1 Stunde nachgerührt. Während dieser Zeit wird die Meßzelle vorbereitet. Sie besteht aus zwei hochtransparenten NaCl-Fenstern, die durch zwei je 25 µm dicke Folien getrennt sind. Die zu messende Polymerprobe wird nun auf eine der Folien aufgetragen, mit der anderen abgedeckt und der Stapel mit den NaCl-Fenstern in einem Metallrahmen so eingespannt, daß zwischen den Folien ein ca. 10 bis 30 µm dicker Film entsteht.

Dieser Sandwich wird mit einer Quecksilber-Höchstdrucklampe (HBO 200 W) im Abstand von 51 cm bestrahlt, wobei durch Interferenzfilter zusätzlich nur eine bestimmte Wellenlänge (z.B. 330, 365, 404 nm)

ausgewählt werden kann.

Vor der Bestrahlung wird ein IR-Spektrum des Proben-Sandwichs gemessen (t = 0) und dies nach 5 s Bestrahlung wiederholt. Bei einem guten Photoinitiator hat die Intensität der den Acrylatgruppen zugeordneten Banden deutlich abgenommen, während die des aromatischen internen Standards unverändert bleiben. Daraus kann für jede Bande eine für den Photoinitiator charakteristische Zahl berechnet werden.

Diese Auswertung wird für die drei intensivsten "Acrylatbanden" durchgeführt und die Werte additiv zur sog. Initiatorkennzahl zusammengefaßt. Diese Kennzahl ist eine reine Maßzahl und umfaßt die Werte 1 bis 15. Je besser ein Initiator die Polymerisation initiiert, umso höher ist seine Kennzahl.

Die Kennzahlen korrelieren mit den für Photopolymere typischen Kenngrößen wie Bleistifthärte und Pendelhärte nach König.

Folgende Werte wurden gefunden:

| Beispiel Nr. | Verbindung | Sensibilisator | Initiatorkennzahl |
|---|---|---|---|
| 35 | 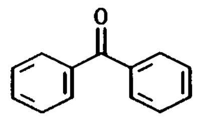 | - | 5.4 |
| 36 | 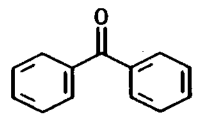 | Michler's Keton | 10.7 |
| 37 | 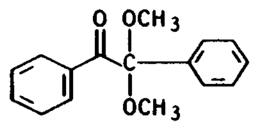 | - | 8.3 |
| 38 | 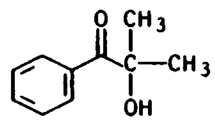 | - | 9.8 |
| 39 | 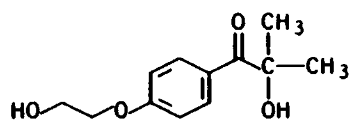 | - | 2.8 |
| 40 | 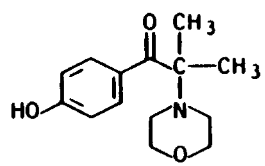 | - | 4.2 |

| Beispiel Nr. | Verbindung | Sensibilisator | Initiatorkennzahl |
|---|---|---|---|
| 41 | 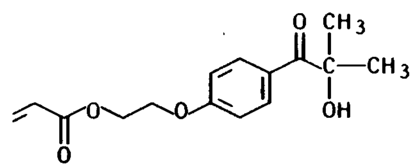 | - | 4.7 |
| 42 | 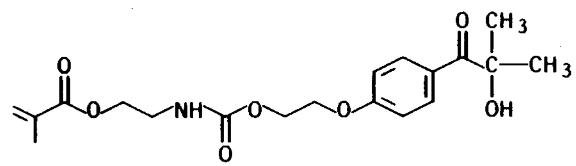 | - | 5.0 |
| 43 | 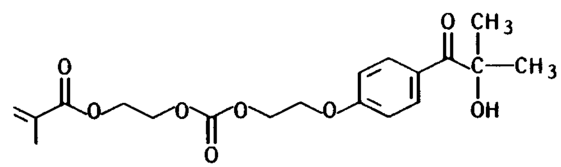 | - | 6.1 |
| 44 | 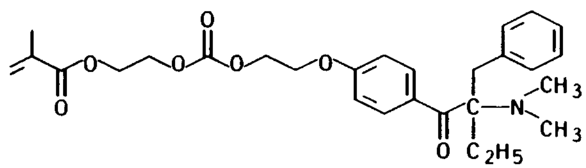 | - | 5.5 |
| 45 | 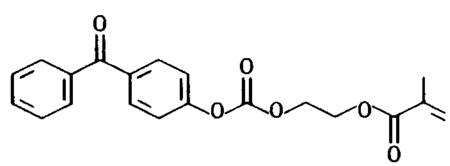 | - | 9.1 |

| Beispiel Nr. | Verbindung | Sensibilisator | Initiator-kennzahl |
|---|---|---|---|
| 46 | 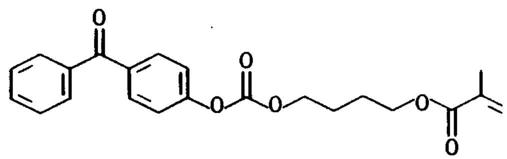 | - | 11.4 |
| 47 | 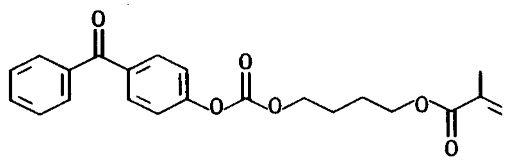 | Michler's Keton | 11.7 |
| 48 | 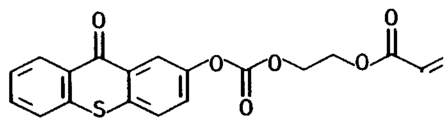 | - | 7.3 |
| 49 | 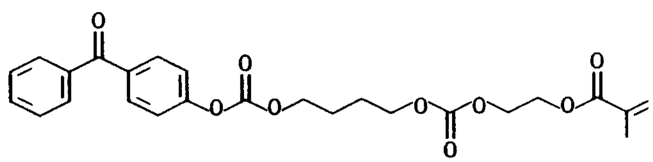 | - | 8.4 |
| 50 | 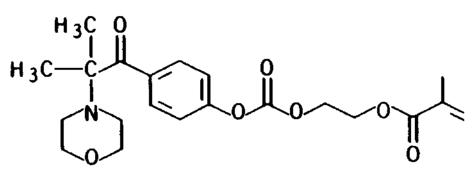 | - | 10.1 |

| Beispiel Nr. | Verbindung | Sensibilisator | Initiator-kennzahl |
|---|---|---|---|
| 51 | 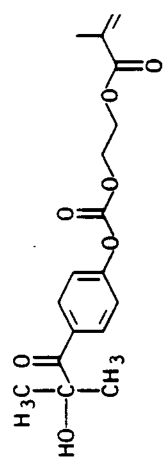 | - | 8.9 |
| 52 | 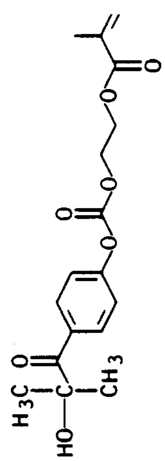 | Thioxanthon | 10.5 |
| 53 | 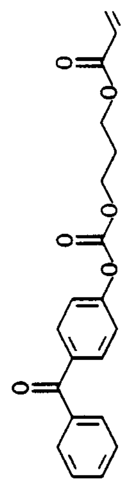 | 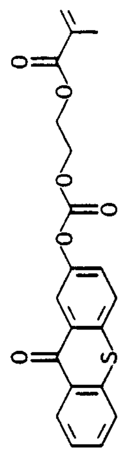 | 9.5 |

Legende zu den Beispielen Nr. :

41 : nach DE-A-35 34 645

42 : in guten Ausbeuten zugänglich aus Darocur® 2959 und Isocyanatoethylmethacrylat

43 : aus Darocur 2959 und 2-Chlorformylethylmethacrylat in 79 % Ausbeute zugänglich

44 : aus 2-Benzyl-2-(dimethylamino)-1-[4-(2-hydroxyethyloxy)-phenyl]butan-1-on und 2-Chlorformylethylmethacrylat in 84 % Ausbeute zugänglich

Die Beispiele 35 bis 44 sind Vergleichsbeispiele.

## Patentansprüche

1. Ethylenisch ungesättigte copolymerisierbare, strahlungsempfindliche organische Verbindungen der allgemeinen Formel (I)

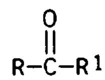 (I),

worin

R für einen geradkettigen Alkylrest mit 1 bis 4 Kohlenstoffatomen, einen verzweigten, gegebenenfalls substituierten Alkylrest mit 3 oder 4 Kohlenstoffatomen, für einen Arylrest oder den Rest $R^1$ steht und

$R^1$ für den Rest

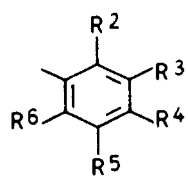

steht, wobei die Reste

$R^2$ bis $R^6$ untereinander gleich oder verschieden sind und für H, Alkyl mit 1 bis 4 Kohlenstoffatomen, Phenyl, OH, $OCH_3$, $OC_2H_5$, SH, $SCH_3$, $SC_2H_5$, F, Cl, Br, CN, COOH, COOAlkyl mit Alkyl enthaltend 1 bis 17 Kohlenstoffatome, COOAryl, $CF_3$, $N(Alkyl)_2$, N(Alkyl) (Aryl), $N(Aryl)_2$, $N^{\oplus}(Alkyl)_3A^{\ominus}$, $N^{\oplus}H(Alkyl)_2A^{\ominus}$ mit Alkyl enthaltend 1 bis 4 Kohlenstoffatome, und $A^{\ominus}$ für das Anion einer Säure stehen und mindestens einer, aber maximal drei der Reste $R^2$ bis $R^6$ für den Rest

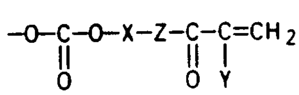 oder 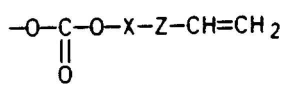

stehen, worin

X für einen zweiwertigen, gegebenenfalls substituierten, gegebenenfalls perfluorierten, Alkylenrest $-(CH_2)_m-$, oder $-(CF_2)_m-$, einen Rest

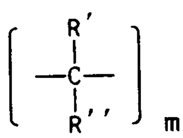 ,

mit m = 1 bis 10,

worin R' und R'' untereinander gleich oder verschieden sind und für Aryl, H, COOH, $COOH_3$, $COOC_2H_5$ oder Alkyl stehen, für einen, gegebenenfalls perfluorierten, Oxaalkylenrest $-(CH_2)_n-O-(CH_2)_p-$oder $-(CF_2)_n-O-(CF_2)_p-$ mit n = 1 bis 5 und p = 1 bis 5 oder einen, gegebenenfalls perfluorierten, Polyoxaalkylenrest mit 2 bis 20 Sauerstoffatomen, die miteinander über mindestens eine $-CH_2-$, $-CF_2-$ oder $-CH_2-CH(CH_3)-$Gruppe verbunden sind, für einen Rest $-(CH_2)_m-O-CO-O-(CH_2)_n-$, $-(CH_2)_n-O-CO-NH-(CH_2)_m-$, $-(CH_2)_n-NH-CO-O-(CH_2)_m-$, $-(CH_2)_m-CO-O-(CH_2)_n-$ oder $-(CH_2)_m-O-CO-(CH_2)_n-$ mit m = 1 bis 10, n = 1 bis 10, für einen, gegebenenfalls substituierten, Cycloalkylenrest mit 5 bis 10 Kohlenstoffatomen, für einen (Bis)methylencycloalkylenrest mit 6 bis 12 Kohlenstoffatomen oder für

einen, gegebenenfalls substituierten, o-, m- oder p-Phenylenrest,
Y für H, Alkyl mit 1 bis 6 Kohlenstoffatomen oder Phenyl und
Z für O oder NY stehen,
oder für den Fall, daß R für einen Arylrest steht, einer der Reste $R^2$ oder $R^6$ für ein Schwefelatom stehen kann, durch das der Arylrest R in ortho-Position mit $R^1$ verbunden ist.

**2.** Verfahren zur Herstellung von Verbindungen der allgemeinen Formel (I), dadurch gekennzeichnet, daß man eine Verbindung der allgemeinen Formel (IIa) oder (IIb)

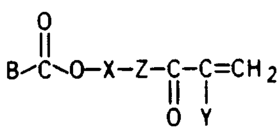
oder
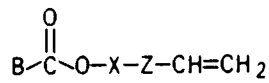
,

(IIa) (IIb),

worin
X, Y und Z die in Anspruch 1 angegebene Bedeutung haben und
B für eine der Gruppen Tosylat, Alkoxy, Halogen, Chlorcarbonyl, Imidazolyl, Pyrazolyl, Phosphonium-, Sulfonium-, Ammonium- oder Pyridiniumkation steht,
mit einer Verbindung der allgemeinen Formel (IIIa)

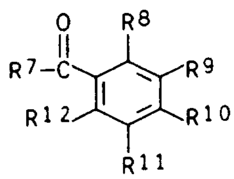

(IIIa),

worin
$R^7$ für einen geradkettigen Alkylrest mit 1 bis 4 Kohlenstoffatomen, einen verzweigten, gegebenenfalls substituierten, Alkylrest mit 3 oder 4 Kohlenstoffatomen oder einen Arylrest steht und worin die Reste $R^8$ bis $R^{12}$ untereinander gleich oder verschieden sind und für H, Alkyl mit 1 bis 4 Kohlenstoffatomen, Phenyl, OH, $OCH_3$, $OC_2H_5$, SH, $SCH_3$, $SC_2H_5$, F, Cl, Br, CN, COOH, COOAlkyl mit Alkyl enthaltend 1 bis 17 Kohlenstoffatome, COOAryl, $CF_3$, $N(Alkyl)_2$, N(Alkyl) (Aryl), $N(Aryl)_2$, $N^{\oplus}(Alkyl)_3A^{\ominus}$, $N^{\oplus}H(Alkyl)_2A^{\ominus}$ mit Alkyl, enthaltend 1 bis 4 Kohlenstoffatome und $A^{\ominus}$ für das Anion einer Säure stehen oder einer der Reste $R^8$ oder $R^{12}$ für ein Schwefelatom stehen kann, durch das der Arylrest in ortho-Position mit $R^7$ verbunden ist, mit der Maßgabe, daß mindestens einer der Reste $R^8$ bis $R^{12}$ für eine Hydroxylgruppe steht, im äquimolaren Verhältnis oder entsprechend der Anzahl der Hydroxylgruppen in den Resten $R^8$ bis $R^{12}$ dem Zwei- oder Dreifachen davon, gegebenenfalls in Gegenwart eines inerten Lösungsmittels oder Lösungsmittelgemisches und eines basischen Katalysators bei Temperaturen von 0 bis 100 °C unter wasserfreien Bedingungen miteinander umsetzt.

**3.** Verfahren zur Herstellung von Verbindungen der allgemeinen Formel (I), dadurch gekennzeichnet, daß man eine Verbindung der allgemeinen Formel (IVa) oder (IVb)

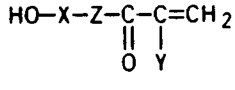
oder
$HO-X-Z-CH=CH_2$

(IVa) (IVb),

worin
X, Y und Z die in Anspruch 1 angegebene Bedeutung haben, mit einer Verbindung der allgemeinen Formel (IIIb)

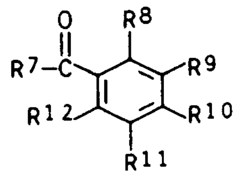

(IIIb),

worin

$R^7$ für einen geradkettigen Alkylrest mit 1 bis 4 Kohlenstoffatomen, einen verzweigten, gegebenenfalls substituierten, Alkylrest mit 3 oder 4 Kohlenstoffatomen oder einen Arylrest steht und worin die Reste $R^8$ bis $R^{12}$ untereinander gleich oder verschieden sind und für H, Alkyl mit 1 bis 4 Kohlenstoffatomen, Phenyl, OH, $OCH_3$, $OC_2H_5$, SH, $SCH_3$, $SC_2H_5$, F, Cl, Br, CN, COOAlkyl mit Alkyl enthaltend 1 bis 17 Kohlenstoffatome, COOAryl, $CF_3$, $N(Alkyl)_2$, N(Alkyl) (Aryl), $N(Aryl)_2$, $N^{\oplus}(Alkyl)_3A^{\ominus}$, $N^{\oplus}H(Alkyl)_2A^{\ominus}$ mit Alkyl, enthaltend 1 bis 4 Kohlenstoffatome, und $A^{\ominus}$ für das Anion einer Säure stehen oder einer der Reste $R^8$ oder $R^{12}$ für ein Schwefelatom stehen kann, durch das der Arylrest in ortho-Position mit $R^7$ verbunden ist, mit der Maßgabe, daß mindestens einer der Reste $R^8$ bis $R^{12}$ für eine Gruppe B-CO-O, worin B für Tosylat, Alkoxy, Halogen, Chlorcarbonyl, Imidazolyl, Pyrazolyl, Phosphonium-, Sulfonium-, Ammonium- oder Pyridiniumkation steht, im äquimolaren Verhältnis oder entsprechend der Anzahl der Gruppen B-CO-O in den Resten $R^8$ bis $R^{12}$ dem Zwei- oder Dreifachen davon, gegebenenfalls in Gegenwart eines inerten Lösungsmittels oder Lösungsmittelgemisches und eines basischen Katalysators, bei Temperaturen von 0 bis 100 °C unter wasserfreien Bedingungen miteinander umsetzt.

**4.** Verfahren nach Anspruch 2, dadurch gekennzeichnet, daß es sich bei den Verbindungen der allgemeinen Formel (IIa) und (IIb) um ω-Chlorformylalkyl-(meth)-acrylate und ω-Chlorformylalkylvinylether handelt.

**5.** Verfahren nach Anspruch 3, dadurch gekennzeichnet, daß es sich bei den Verbindungen der allgemeinen Formel (IIIb) um ein gegebenenfalls substituiertes Chlorformylacetophenon, Chlorformylbenzophenon oder Chlorformylthioxanthon handelt.

**6.** Verfahren nach einem der Ansprüche 2 bis 5, dadurch gekennzeichnet, daß mindestens eine äquimolare Menge einer starken, nicht nucleophilen Base, vorzugsweise eines tertiären Amins, anwesend ist.

**7.** Verfahren nach einem der Ansprüche 2 bis 6, dadurch gekennzeichnet, daß die Reaktionstemperatur im Bereich von 20 bis 60 °C liegt.

**8.** Verfahren nach einem der Ansprüche 2 bis 7, dadurch gekennzeichnet, daß in einem inerten, wasserfreien Lösungsmittel, gegebenenfalls unter Feuchtigkeitsausschluß, gearbeitet wird.

**9.** Strahlungsempfindliches Gemisch, dadurch gekennzeichnet, daß es als Photoinitiator mindestens eine ethylenisch ungesättigte, copolymerisierbare organische Verbindung nach Anspruch 1, gegebenenfalls im Gemisch mit weiteren reaktiven ethylenisch ungesättigten Verbindungen, Sensibilisatoren und weiteren üblichen Zusatzstoffen enthält.

**10.** Verwendung der copolymerisierbaren ethylenisch ungesättigten Verbindungen nach Anspruch 1 zur Herstellung polymerer, strahlungsempfindlicher Verbindungen.

**11.** Verwendung der Vinylether-Monomeren nach Anspruch 1 als reaktive Komponenten bei kationischen Polymerisationen zur Herstellung polymerer, strahlungsempfindlicher Verbindungen und als Comonomere in Hybrid-(Double-Cure)Systemen.

## Claims

1. An ethylenically unsaturated copolymerizable, radiation-sensitive organic compound of the formula (I)

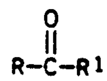

(I)

where
R is straight-chain alkyl of 1 to 4 carbon atoms, branched, unsubstituted or substituted alkyl of 3 or 4 carbon atoms, aryl or a radical $R^1$ and
$R^1$ is a radical

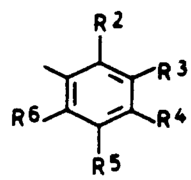

where
$R^2$ to $R^6$ are identical or different and are each H, alkyl of 1 to 4 carbon atoms, phenyl, OH, $OCH_3$, $OC_2H_5$, SH, $SCH_3$, $SC_2H_5$, F, Cl, Br, CN, COOH, COOAlkyl where alkyl is of 1 to 17 carbon atoms, COOAryl, $CF_3$, $N(Alkyl)_2$, N(Alkyl)(Aryl), $N(Aryl)_2$, $N^{\oplus}(Alkyl)_3A^{\ominus}$ or $N^{\oplus}H(Alkyl)_2A^{\ominus}$ where alkyl is of 1 to 4 carbon atoms, and $A^{\ominus}$ is the anion of an acid, and at least but not more than three of the radicals $R^2$ to $R^6$ is a radical

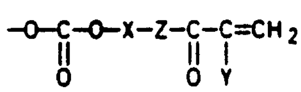

or

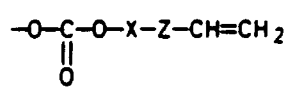

where
X is a divalent, unsubstituted or substituted alkylene radical which may be perfluorinated, ie. - $(CH_2)_m$- or -$(CF_2)_m$-, a radical

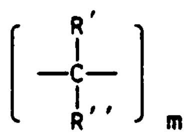

where m is from 1 to 10 and
R' and R'' are identical or different and are each aryl, H, COOH, $COOCH_3$, $COOC_2H_5$ or alkyl, an oxaalkylene radical which may be perfluorinated, ie. -$(CH_2)_n$-O-$(CH_2)_p$- or -$(CF_2)_n$-O-$(CF_2)_p$- where n and p are each from 1 to 5, or a polyoxaalkylene radical which may be perfluorinated and has 2 to 20 oxygen atoms which are bonded to one another via at least one -$CH_2$-, -$CF_2$- or -$CH_2$-$CH(CH_3)$- group, or a radical - $(CH_2)_m$-O-CO-O- $(CH_2)_n$-, - $(CH_2)_n$-O-CO-NH-$(CH_2)_m$-,-$(CH_2)_n$-NH-CO-O-$(CH_2)_m$-, - $(CH_2)_m$-CO-O-$(CH_2)_n$- or -$(CH_2)_m$-O-CO-$(CH_2)_n$- where m and n are each from 1 to 10, an unsubstituted or substituted cycloalkylene radical of 5 to 10 carbon atoms, a (bis)methylenecycloalkylene radical of 6 to 12 carbon atoms or an unsubstituted or substituted o-, m- or p-phenylene radical,
Y is H, alkyl of 1 to 6 carbon atoms or phenyl and
Z is O or NY,
or, if R is aryl, one of the radicals $R^2$ or $R^6$ may be a sulfur atom by means of which the aryl radical R is bonded in the ortho-position with $R^1$.

**2.** A process for the preparation of a compound of the formula (I), wherein a compound of the formula (IIa) or (IIb)

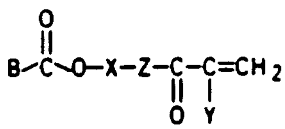 or 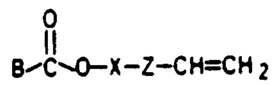

(IIa) (IIb)

where
X, Y and Z have the meanings stated in claim 1 and
B is one of the groups tosylate, alkoxy, halogen, chlorocarbonyl, imidazolyl, pyrazolyl or a phosphonium, sulfonium, ammonium or pyridinium cation,
is reacted with a compound of the formula (IIIa)

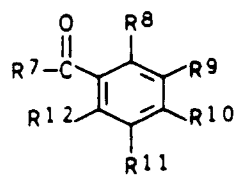

(IIIa)

where
$R^7$ is straight-chain alkyl of 1 to 4 carbon atoms, branched, unsubstituted or substituted alkyl of 3 or 4 carbon atoms or aryl, and
$R^8$ to $R^{12}$ are identical or different and are each H, alkyl of 1 to 4 carbon atoms, phenyl, OH, $OCH_3$, $OC_2H_5$, SH, $SCH_3$, $SC_2H_5$, F, Cl, Br, CN, COOH, COOAlkyl where alkyl is of 1 to 17 carbon atoms, COOAryl, $CF_3$, $N(Alkyl)_2$, N(Alkyl)(Aryl), $N(Aryl)_2$, $N^{\oplus}(Alkyl)_3A^{\ominus}$ or $N^{\oplus}H(Alkyl)_2A^{\ominus}$ where alkyl is of 1 to 4 carbon atoms and $A^{\ominus}$ is the anion of an acid, or one of the radicals $R^8$ or $R^{12}$ may be a sulfur atom by means of which the aryl radical is bonded in the orthoposition with $R^7$, with the proviso that at least one of the radicals $R^8$ to $R^{12}$ is hydroxyl, in an equimolar ratio or, depending on the number of hydroxyl groups in the radicals $R^8$ to $R^{12}$, in two or three times the equimolar ratio, in the presence or absence of an inert solvent or solvent mixture and of a basic catalyst, at from 0 to 100 °C under anhydrous conditions.

**3.** A process for the preparation of a compound of the formula (I), wherein a compound of the formula (IVa) or (IVb)

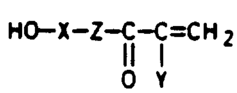 or 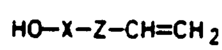

(IVa) (IVb)

where
X, Y and Z have the meanings stated in claim 1, is reacted with a compound of the formula (IIIb)

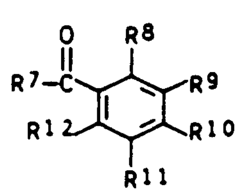

(IIIb)

where

$R^7$ is straight-chain alkyl of 1 to 4 carbon atoms, branched, unsubstituted or substituted alkyl of 3 or 4 carbon atoms or aryl, and
$R^8$ to $R^{12}$ are identical or different and are each H, alkyl of 1 to 4 carbon atoms, phenyl, OH, $OCH_3$, $OC_2H_5$, SH, $SCH_3$, $SC_2H_5$ F, Cl, Br, CN, COOAlkyl where alkyl is of 1 to 17 carbon atoms, COOAryl, $CF_3$, $N(AlXyl)_2$, N(Alkyl)(Aryl), $N(Aryl)_2$, $N^{\oplus}(Alkyl)_3A^{\ominus}$ or $N^{\oplus}H(Alkyl)_2A^{\ominus}$ where alkyl is of 1 to 4 carbon atoms, and $A^{\ominus}$ is the anion of an acid, or one of the radicals $R^8$ or $R^{12}$ may be a sulfur atom by means of which the aryl radical is bonded in the ortho-position with $R^7$, with the proviso that at least one of the radicals $R^8$ to $R^{12}$ is a group B-CO-O, where B is tosylate, alkoxy, halogen, chlorocarbonyl, imidasolyl, pyrazolyl or a phosphonium, sulfonium, ammonium or pyridinium cation, in an equimolar ratio or, depending on the number of B-CO-O groups in the radicals $R^8$ to $R^{12}$, in two or three times the equimolar ratio, in the presence or absence of an inert solvent or solvent mixture and of a basic catalyst, at from 0 to 100 °C under anhydrous conditions.

**4.** A process as claimed in claim 2, wherein the compounds of the formulae (IIa) and (IIb) are ω-chloroformylalkyl (meth)acrylates and ω-chloroformylalkyl vinyl ethers.

**5.** A process as claimed in claim 3, wherein the compounds of the formula (IIIb) are unsubstituted or substituted chloroformylacetophenones, chloroformylbenzophenones or chloroformylthioxanthones.

**6.** A process as claimed in any of claims 2 to 5, wherein at least an equimolar amount of a strong, nonnucleophilic base, preferably of a tertiary amine, is present.

**7.** A process as claimed in any of claims 2 to 6, wherein the reaction temperature is from 20 to 60 °C.

**8.** A process as claimed in any of claims 2 to 7, wherein the reaction is carried out in an inert, anhydrous solvent, if necessary with exclusion of moisture.

**9.** A radiation-sensitive mixture, which contains, as a photoinitiator, at least one ethylenically unsaturated, copolymerisable organic compound as claimed in claim 1, if necessary as a mixture with further reactive ethylenically unsaturated compounds, sensitizers and other conventional additives.

**10.** The use of copolymerizable ethylenically unsaturated compounds as claimed in claim 1 to prepare polymeric, radiation-sensitive compounds.

**11.** The use of vinyl ether monomers as claimed in claim 1 as reactive components in catalytic polymerization to prepare polymeric, radiation-sensitive compounds and as comonomers in hybrid double-cure systems.

## Revendications

**1.** Composés organiques à insaturation éthylénique copolymérisables, sensibles aux rayonnements, de formule générale I

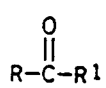

(I),

dans laquelle
R représente un groupe alkyle à chaîne droite en C1-C4, un groupe alkyle ramifié, éventuellement substitué, en C3 ou C4, un groupe aryle ou bien le groupe $R^1$, et
$R^1$ représente le groupe

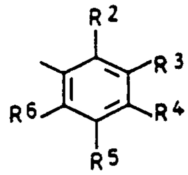

dans lequel
$R^2$ à $R^6$, ayant des significations identiques ou différentes, représentent chaun H, un groupe alkyle en C1-C4, phényle, OH, $OCH_3$, $OC_2H_5$, SH, $SCH_3$, $SC_2H_5$, F, Cl, Br, CN, COOH, COO-alkyle dans lequel la partie alkyle est en C1-C17, COO-aryle, $CF_3$, N-(alkyle)$_2$, N-(alkyle)(aryle), N-(aryle)$_2$, $N^{\oplus}$(alkyle)$_3A^{\ominus}$, $N^{\oplus}$H(alkyle)$_2A^{\ominus}$ dans lesquels les parties alkyle sont en C1-C4 et $A^{\ominus}$ représente l'anion d'un acide, et au moins un mais au maximum trois des symboles $R_2$ à $R_6$ représentent un groupe

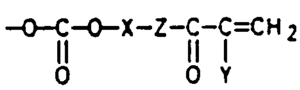 ou 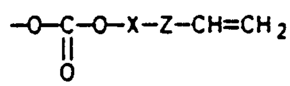

dans lequel X représente un groupe alkylène divalent, éventuellement substitué, éventuellement pertluoré, $-(CH_2)_m-$ ou $-(CF_2)_m-$,
un groupe

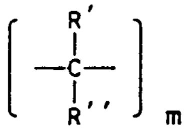 ,

dans lequel m = 1 à 10,
et R' et R'', ayant des significations identiques ou différentes, représentent chacun un groupe aryle, H, COOH, $COOHCH_3$, $COOC_2H_5$ ou alkyle, un groupe oxa-alkylène éventuellement pertluoré $-(CH_2)_n-O-(CH_2)_p-$ ou - $(CF_2)_n-O-(CF_2)_p-$ dans lequels n égal 1 à 5 et p = 1 à 5, ou un groupe polyoxa-alklène éventuellement perfluoré contenant 2 à 20 atomes d'oxygène reliés entre eux par au moins un groupe $-CH_2-$, $-CF_2-$ ou $-CH_2-CH(CH_3)-$, un groupe - $(CH_2)_m-O-CO-O-(CH_2)_n-$, $-(CH_2)_n-O-CO-NH-(CH_2)_m-$, $-(CH_2)_n-NH-CO-O-(CH_2)_m-$, $-(CH_2)_m-CO-O-(CH_2)_n-$ ou $-(CH_2)_m-O-CO-(CH_2)_n-$ dans lesquels m = 1 à 10, n = 1 à 10, un groupe cycloalkylène, éventuellement substitué, en C5-C10, un groupe (bis)-méthylène-cycloalkylène contenant 6 à 12 atomes de carbone, ou un groupe O-, m- ou p-phénylène éventuellement substitué
Y représente H, un groupe alkyle en C1-C6 ou phényle, et
Z représente O ou NY,
ou bien, dans le cas où R représente un groupe aryle, l'un des symboles $R^2$ ou $R^6$ peut représenter un atome de soufre reliant le groupe aryle R en position ortho avec $R^1$.

**2.** Procédé de préparation des composés de formule générale I, caractérisé en ce que l'on fait réagir entre eux un composé de formule générale IIa ou IIb

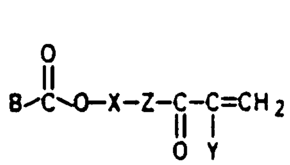 ou 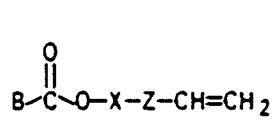 ,

(IIa) (IIb),

dans laquelle
X, Y, et Z ont les significations indiquées dans la revendication 1, et
B représente l'un des substituants toluène-sulfonate, alcoxy, halogéno, chlorocarbonyle, imidazolyle,

pyrazolyle, un cation phosphonium, sulfonium, ammonium ou pyridinium, et un composé de formule générale IIIa

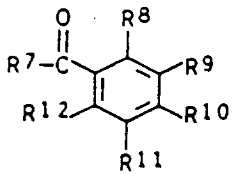

(IIIa),

dans laquelle

$R^7$ représente un groupe alkyle à chaîne droite en C1-C4, un groupe alkyle ramifié éventuellement substitué en C3 ou C4, ou un groupe aryle, et les symboles

$R^8$ à $R^{12}$, ayant des significations identiques ou différentes, représentent chacun H, un groupe alkyle en C1-C4, phényle, OH, $OCH_3$, $OC_2H_5$, SH, $SCH_3$, $SC_2H_5$, F, C1, Br, CN, COOH, COO-alkyle dont la partie alkyle est en C1-C17, COO-aryle, $CF_3$, N-$(alkyle)_2$, N-(alkyle)(aryle), N-$(aryle)_2$, $N^{\oplus}(alkyle)_3A^{\ominus}$, $N^{\oplus}H(alkyle)_2A^{\ominus}$ dans lesquels les parties aryle sont en C1-C4 et $A^{\ominus}$ représente l'anion d'un acide, l'un des symboles $R^8$ ou $R^{12}$ pouvant également représenter un atome de soufre reliant le groupe aryle en position ortho avec $R^7$, sous réserve qu'au moins un des symboles $R^8$ à $R^{12}$ représente un groupe hydroxy,

en quantité équimoléculaires, ou bien, selon le nombre des groupes hydroxy des substituants $R^8$ à $R^{12}$, en quantités de deux ou trois fois le rapport équimoléculaire, en présence d'un solvant ou mélange solvant inerte et d'un catalyseur basique, à des températures de 0 à 100 °C en milieu anhydre.

**3.** Procédé de préparation des composés de formule générale I, caractérisé en ce que l'on fait réagir entre eux un composé de formule générale IVa ou IVb

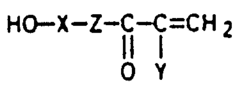 ou 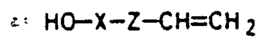

(IVa) (IVb),

dans laquelle

X, Y et Z ont les significations indiquées dans la revendication 1, et un composé de formule générale IIIb

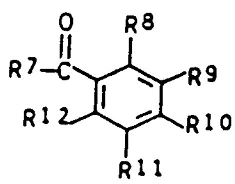

(IIIb),

dans laquelle

$R^7$ représente un groupe alkyle à chaîne droite en C1-C4, un groupe alkyle ramifié, éventuellement substitué, en C3 ou C4 ou un groupe aryle, et les symboles

$R^8$ à $R^{12}$, ayant des significations identiques ou différentes, représentent chacun

H, un groupe alkyle en C1-C4, phényle, OH, $OCH_3$, $OC_2H_5$, SH, $SCH_3$, $SC_2H_5$, F, C$^l$, Br, CN, COO-alkyle dans lequel la partie alkyle est en C1-C17, COO-aryle, $CF_3$, $N(alkyle)_2$, N(alkyle)(aryle), $N(aryle)_2$, $N^{\oplus}(alkyle)_3A^{\ominus}$, $N^{\oplus}H(alkyle)_2A^{\ominus}$ dans lesquels les parties alkyle contiennent 1 à 4 atomes de carbone et $A^{\ominus}$ représente l'anion d'un acide, ou bien l'un des symboles $R^8$ ou $R^{12}$ représente un atome de soufre qui relie le groupe aryle en position ortho avec $R^7$, sous réserve qu'au moins un des symboles $R^8$ à $R^{12}$ représente un groupe B-CO-O dans lequel B représente un substituant toluène-sulfonate, alcoxy, halogéno, chlorocarbonyle, imidazolyle, pyrazolyle, un cation phosphonium, sulfonium, ammonium ou pyridinium, dans des proportions équimoléculaires ou bien, selon le nombre des groupes B-CO-O dans

les substituants $R^8$ à $R^{12}$, dans des proportions doubles ou triples des proportions équimoléculaires, éventuellement en présence d'un solvant ou mélange solvant inerte et d'un catalyseur basique, à des températures de 0 à 100 °C et en milieu anhydre.

**4.** Procédé selon la revendication 2, caractérisé en ce que les composés de formules générales IIa et IIb sont des (méth)acrylates d'oméga-chloroformylalkyle et des éthers oméga-chloroformylalkylvinyliques.

**5.** Procédé selon la revendication 3, caractérisé en ce que les composés de formule générale IIIb selon la chloroformylacétophénone éventuellement substituée, la chloroformylbenzophénone ou la chloroformylthioxanthone.

**6.** Procédé selon une des revendications 2 à 5, caractérisé en ce que l'on opère en présence de la quantité au moins équimoléculaire d'une base forte non nucléophile, de préférence d'une amine tertiaire.

**7.** Procédé selon l'une des revendications 2 à 6, caractérisé en ce que la température de réaction se situe dans l'intervalle de 20 à 60 °C.

**8.** Procédé selon l'une des revendications 2 à 7, caractérisé en ce que l'on opère dans un solvant inerte anhydre, éventuellement à l'abri de l'humidité.

**9.** Mélange sensible aux rayonnements, caractérisé en ce qu'il contient en tant que photo-inducteur au moins un composé organique à insaturation éthylénique copolymérisable selon la revendication 1, éventuellement en mélange avec d'autres composés à insaturation éthylénique réactifs, des sensibilisants et d'autres additifs usuels.

**10.** Utilisation des composés à insaturation éthylénique copolymérisables selon la revendication 1 pour la préparation de composés polymères sensibles aux rayonnements.

**11.** Utilisation des éthers vinyliques monomères selon la revendication 1 en tant que composants réactifs dans des polymérisations cationiques pour la préparation de composés polymères sensibles au rayonnements et en tant que comonomères dans des systèmes "hybrid-(double-cure)".